# EUROPEAN PATENT SPECIFICATION

(11) **EP 0 487 421 B1**
(45) Date of publication and mention of the grant of the patent: **02.05.1997**
(21) Application number: 91403144.8
(22) Date of filing: 21.11.1991
(51) Int. Cl.: H01L 39/24

(54) **Process for preparing a thin film of Bi-type oxide superconductor**
Verfahren zum Herstellen einer Dünnschicht aus einem Oxid-Supraleiter vom Wismuth-Typ
Procédé pour préparation d'un film mince en oxyde supraconducteur de type Bi

(30) Priority: 21.11.1990 JP 316748/90
(43) Date of publication of application: 27.05.1992
(73) Proprietor: Sumitomo Electric Industries, Ltd., Osaka 541 (JP)
(72) Inventor: Hattori, Hisao, c/o Itami Works, Itami-shi, Hyogo (JP); Higaki, Kenjiro, c/o Itami Works, Itami-shi, Hyogo (JP); Itozaki, Hideo, c/o Itami Works, Itami-shi, Hyogo (JP)
(74) Representative: Bernasconi, Jean

(56) References cited:
- EP-A- 0 343 649
- APPLIED PHYSICS LETTERS vol. 55, no. 4, 4 September 1989, NEW YORK, US pages 1035 - 1037; Kageyama Y. et al: 'Effect of a declination angle of substrate position on magnetron sputter deposition from YBa2Cu3O7-x target'
- APPLIED PHYSICS LETTERS vol. 57, no. 19, 5 November 1990, NEW YORK, US pages 2019 - 2021; Lee.A.E. et al: 'Epitaxially grown sputtered LaAlO3 films'
- IEEE TRANSACTION ON MAGNETICS, vol.27, no.2, March 1991, pages 982-989, New York, US & APPLIED SUPERCONDUCTIVITY CONFERENCE, September 1990, Snowmass, US; Xi X.X. et al: "Preparation of thin film high temperature superconductors"
- PATENT ABSTRACTS OF JAPAN vol. 14, no. 334 (C-074)18 July 1990 & JP-A-2 122 067

## Description

### Background of the Invention

### Field of the Invention

The present invention relates to a process for preparing a thin film of Bi-type oxide superconductor, more particularly to a process for depositing a single crystal thin film of Bi-type oxide superconductor whose c-axis is oriented in parallel with a surface of a substrate.

### Description of the related arts

Oxide superconductors of the Bi-Sr-Ca-Cu-O system (hereinafter, Bi-type oxide superconductors) possess a critical temperature higher than that of the Y-Ba-Cu-O system and hence are expected to be applicable in actual uses.

In the meantime, it is indispensable to prepare thin films of such oxide superconductors in order to utilize them in actual uses of electronics devices such as Josephson devices and superconducting transistors. Today, it is possible to prepare a thin film of single crystal of oxide superconductor in the case of the Y-Ba-Cu-O system by a variety of techniques including the sputtering method, the vacuum evaporation method, the laser abrasion method and the like.

However, in the case of the Bi-type oxide superconductors, it is impossible or difficult to prepare a thin film of well-crystalline single crystal for several reasons, in particular, because more than two phases each having a different superconducting property are produced simultaneously.

It is known that the Bi-type oxide superconductors show anisotropy in their superconducting properties. In fact, their crystals show a critical current density (Jc) which is higher in a direction perpendicular to the c-axis than in the other directions. In many superconducting devices, additional layer(s) is (are) deposited on the thin film of Bi-type oxide superconductor. In such devices, the thin film of Bi-type oxide superconductor is requested to have such a crystal orientation that the c-axis of the thin film is oriented in parallel with a surface of a substrate in order to flow a higher critical current in a direction (depth-wise direction) which is perpendicular to the surface of the substrate.

However, the c-axis of thin films of Bi-type oxide superconductor prepared by known techniques is oriented perpendicularly to the surface of the substrate. In other words, it is difficult to prepare a single crystal thin film of Bi-type oxide superconductor whose c-axis is oriented in parallel with the surface of the substrate, so that thin films of Bi-type oxide superconductor prepared by known techniques cannot be utilized advantageously in superconducting electronics devices.

In addition, thin films of Bi-type oxide superconductor prepared by known techniques have not a smooth surface and show relatively poor superconducting properties and hence cannot be used in actual uses.

Further, the conventional processes cannot produce stably or reproducibly thin films of Bi-type oxide superconductor having uniform properties.

X.X.Xi et al. "Preparation of thin film high temperature superconductors", IEEE Transactions on Magnetics, vol. 27, No. 2, pp 982-989, New York, US and Applied Superconductivity Conference, September 24-28, 1990, Snowmass, US, report essentially Inverted Cylindrical Magnetron Sputtering (ICMS) or Pulsed Laser Deposition (PLD) methods, to produce a-axis oriented YBCO-type thin films together with the structural and superconducting properties of the thin films thus obtained.

An object of the present invention is to solve the problems above described and to provide a process for preparing a single crystal thin film of Bi-type oxide superconductor whose c-axis is oriented in parallel with a surface of a substrate.

### Summary of the Invention

The present invention provides a process of preparing a single crystal thin film made of oxide superconductor of Bi, Sr, Ca and Cu on a substrate and possessing a c-axis oriented in parallel with a surface of the substrate by using the so-called "off-axis sputtering" method wherein a target made of a sintered oxide of Bi, Sr, Ca and Cu is placed on a cathode and the sputtering is effected under such a condition that the surface of the substrate makes an angle of substantially 90° with respect to a surface of the target at a substrate temperature between 500°C and 750°C at a gas pressure between 1.33 and 133 Pa (0.01 Torr and 1 Torr).

The sputtering is effected by magnetron sputtering in which a high-frequency power between 10 W and 1,000 W is applied to the cathode. The sputtering is effected in the presence of a mixed gas of argon and oxygen with an oxygen volume ratio of O₂ /(Ar + O₂) which is more than 0.05.

According to the process of the present invention, any one of single crystal thin films each made of a different single phase can be prepared by selecting a target composition. The single crystal thin film according to the present invention has preferably a composition selected from a group consisting of Bi₂Sr₂Ca₂Cu₃Oₓ and Bi₂Sr₂Ca₁Cu₂Oₓ.

The deposition rate is selected preferably between 0.01 to 10 nm/sec (0.1 and 100 Å/sec). The thin film can have a thickness of at least 5nm (50 Å).

The single crystal thin film of Bi-Sr-Ca-Cu-O oxide obtained by the present invention has a c-axis which is oriented in parallel with the surface of the substrate. In other words, the critical current which flows along a depth-wise direction of the thin film is larger than that along a direction which is parallel with the surface of the substrate so that the thin film prepared by the process according to the present invention is advantageous to fabricate multi-layered superconducting devices in which additional layer(s) will be deposited thereon.

The process of the present invention permits to obtain a single crystal thin film of oxide superconductor of the Bi-Sr-Ca-Cu-O system having an improved quality without increasing the manufacturing cost because the process according to the present invention can be carried out simply by selecting optimum operational conditions.

The process according to the present invention is expected to promote the actual application of the oxide superconductors in the field of electronics devices.

Now, the present invention will be described with reference to the accompanying drawing.

### Brief Description of the Drawing

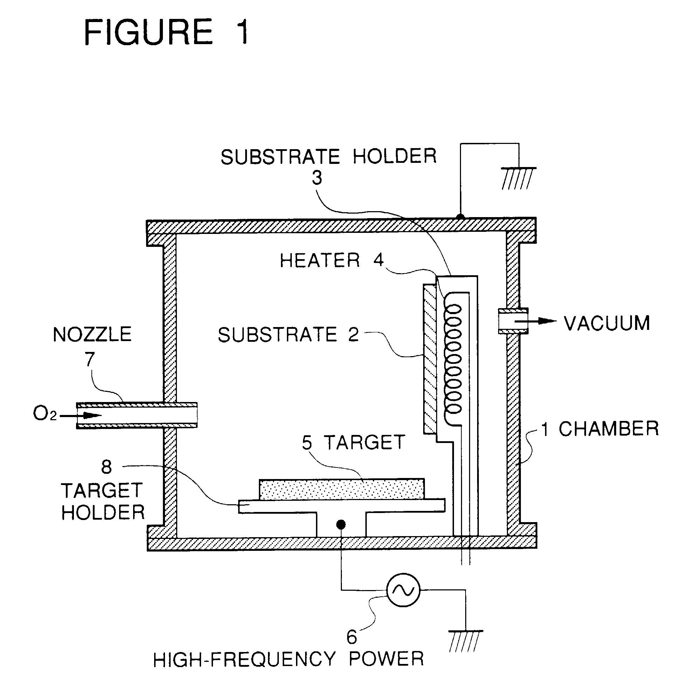

Fig. 1 is an illustrative cross-sectional view of an apparatus which can be used for carrying out the process according to the present invention.

The apparatus shown in Fig. 1 has a vacuum chamber 1 having a gas inlet 7. In the vacuum chamber 1, there are a substrate holder 3 for securing a substrate 2 thereto and a target holder 8 for securing a target 5 thereto. A heater 4 is arranged inside the substrate holder 3.

According to the present invention, the substrate holder 3 is secured above the target 5 at such a relative position that the surface of the substrate 2 makes an angle of 90° relative to the surface of the target 5 at an edge of the target 5.

High-frequency power is applied to the target holder 8 from a high-frequency source 6 arranged outside the chamber 1.

### Description of the Preferred Embodiments

Now, the present invention will be described with reference to Examples, but the scope of the invention should not be limited thereto.

### Example 1

A thin film of oxide superconductor of Bi₂Sr₂Ca₁Cu₂Oₓ was prepared by using the apparatus of Fig.1.

A (100) MgO substrate was used as the substrate 2. As the target 5, a sintered oxide of Bi, Sr, Ca and Cu having atomic ratios of Bi:Sr:Ca:Cu = 1.8:2:1: 1.8 was used.

In operation, a sputtering gas consisting of a mixture of Ar and O₂ was introduced into the chamber 1 at a gas pressure of 6.65 Pa (0.05 Torr) with a partial pressure ratio of Ar : O₂ = 4 : 1. The substrate 2 was heated to 570°C by the heater 4. High-frequency power was applied to the target holder. A thin film was grown up to a thickness of 6,000 Å at a deposition rate of 0.8 Å/sec.

After a thin film was obtained, the crystal structure of the resulting thin film was evaluated by a scanning electron spectroscopy (SEM) and a reflective high-energy electron diffraction analyzer (RHEED) and the critical temperature was determined by measuring electric resistance by the usual four probe method.

The results revealed that the resulting thin film was a thin film of single crystal composed of Bi₂Sr₂Ca₁Cu₂Oₓ whose c-axis was oriented in parallel with the surface of the substrate and having a smooth surface of high quality. The critical temperature was 70 K.

### Example 2

Example 1 was repeated by using the same apparatus as in Example 1 but the target composition was modified in order to prepare a thin film of oxide superconductor consisting of Bi₂Sr₂Ca₂Cu₃Oₓ.

In this Example 2, the target 5 was changed to a sintered oxide of Bi, Sr, Ca and Cu having atomic ratios of Bi:Sr:Ca:Cu = 1.9: 2: 2: 2.3. The other operational conditions were the same as in Example 1.

After a thin film was obtained, the crystal structure of the resulting thin film was evaluated and the critical temperature was determined by the same method as in Example 1.

The results revealed that the resulting thin film is a thin film of single crystal composed of Bi₂Sr₂Ca₂Cu₃Oₓ whose c-axis was oriented in parallel with the surface of the substrate and having a smooth surface of high quality. The critical temperature was 104 K.

The thin films obtained by Examples 1 and 2 were improved in quality over those obtained by known processes.

## Claims

1. A process of preparing a single crystal thin film made of an oxide superconductor of Bi, Sr, Ca and Cu on a substrate (2) and possessing a c-axis oriented in parallel with a surface of said substrate (2) by using the method of off-axis sputtering wherein a target (5) made of a sintered oxide of Bi, Sr, Ca and Cu is placed on a cathode (8) and said sputtering is effected under such a condition that said surface of the substrate (2) makes an angle of substantially 90° with respect to the surface of said target (5) at a substrate temperature between 500°C and 750°C at a gas pressure between 1.33 and 133 Pa (0.01 Torr and 1 Torr), said sputtering is effected by magnetron sputtering at a high-frequency power between 10 W and 1,000 W applied to said cathode, said sputtering is effected in the presence of a mixed gas of argon and oxygen with an oxygen volume ratio of O₂/(Ar+O₂) of more than 0.05.

2. The process set forth in claim 1, wherein said single crystal thin film has a composition selected from the group consisting of Bi₂Sr₂Ca₂Cu₃Oₓ and Bi₂Sr₂Ca₁Cu₂Oₓ.

3. The process set forth in any one of claims 1 or 2, wherein said sputtering is effected at a deposition rate between 0.01 and 10 nm/sec (0.1 and 100 Å/sec).

4. The process set forth in any one of claims 1 to 3, wherein said thin film has a thickness of at least 5nm (50 Å).

## Patentansprüche

1. Verfahren zur Herstellung einer Einkristall-Dünnschicht aus einem oxidischem Supraleiter aus Bi, Sr, Ca und Cu auf einem Substrat (2), welche eine c-Achsorientierung parallel zur Oberfläche des Substrates (2) aufweist unter Verwendung des Verfahrens der achsversetzten Zerstäubung, bei dem ein Target (5) aus einem Sinteroxid aus Bi, Sr, Ca und Cu auf einer Kathode (8) angeordnet wird und die Zerstäubung unter der Bedingung durchgeführt wird, daß die Oberfläche des Substrats (2) einen Winkel von im wesentlichen 90° bezüglich der Oberfläche des Targets (5) einnimmt bei einer Substrattemperatur zwischen 500°C und 750°C und bei einem Gasdruck zwischen 1,33 und 133 Pa (0,01 Torr und 1 Torr), wobei die Zerstäubung eine Magnetron-Zerstäubung ist bei einer Hochfrequenzleistung zwischen 10 W und 1000 W an der Kathode und wobei die Zerstäubung in Gegenwart eines Gasgemisches aus Argon und Sauerstoff durchgeführt wird, mit einem Volumenverhältnis von O₂/(Ar+O₂) von mehr als 0,05.

2. Verfahren nach Anspruch 1, bei dem die Einkristall-Dünnschicht eine Zusammensetzung aufweist, die ausgewählt ist aus der Gruppe bestehend aus Bi₂Sr₂Ca₂Cu₃Oₓ und Bi₂Sr₂Ca₁Cu₂Oₓ.

3. Verfahren nach einem der Ansprüche 1 oder 2, bei dem die Zerstäubung bei einer Abscheiderate zwischen 0,01 und 10 nm/sec (0,1 und 100 Å/sec) durchgeführt wird.

4. Verfahren nach einem der Ansprüche 1 bis 3, bei dem die Dünnschicht eine Dicke von wenigstens 5 nm (50 Å) aufweist.

## Revendications

1. Procédé de préparation d'un film mince monocristallin d'un supraconducteur de type oxyde dérivé de Bi, Sr, Ca et Cu, sur un substrat (2), et dont l'axe c est orienté parallèlement à la surface de ce substrat (2), en mettant en oeuvre le procédé de pulvérisation cathodique désaxée, selon lequel on dispose sur une cathode (8), une cible (5) en un oxyde fritté de Bi, Sr, Ca et Cu, cette pulvérisation cathodique étant effectuée dans des conditions telles que ladite surface du substrat (2) fasse un angle d'environ 90° par rapport à la surface de la cible (5), à une température de substrat de 500 °C à 750 °C sous une pression de gaz de 1,33 à 133 Pa (de 0,01 torr à 1 torr), cette pulvérisation cathodique étant effectuée par pulvérisation à l'aide d'un magnétron à une puissance à haute fréquence de 10 W à 1 000 W appliquée à ladite cathode, cette pulvérisation cathodique étant effectuée en présence d'un gaz mixte d'argon et d'oxygène selon un taux volumique d'oxygène O₂/(Ar+O₂) supérieur à 0,05.

2. Procédé selon la revendication 1, dans lequel le film mince monocristallin a une composition choisie parmi Bi₂Sr₂Ca₂Cu₃Oₓ et Bi₂Sr₂Ca₁Cu₂Oₓ.

3. Procédé selon l'une quelconque des revendications 1 et 2, dans lequel la pulvérisation cathodique est effectuée à une vitesse de dépôt de 0,01 à 10 nm/s (de 0,1 à 120 Å/s).

4. Procédé selon l'une quelconque des revendications 1 à 3, dans lequel le film mince a une épaisseur d'au moins 5 nm (50 Å).
